# EUROPÄISCHE PATENTSCHRIFT

(11) **EP 0 553 465 B1**
(45) Veröffentlichungstag und Bekanntmachung des Hinweises auf die Patenterteilung: **28.06.1995**
(21) Anmeldenummer: 92121412.8
(22) Anmeldetag: 16.12.1992
(51) Int. Cl.: C30B 33/00, C30B 29/06, H01L 21/306, C25F 3/12, G02B 5/20

(54) **Verfahren zur Herstellung eines perforierten Werkstückes**
Process for the manufacture of a perforated work article
Procédé pour la production d'une pièce d'oeuvre perforée

(30) Priorität: 29.01.1992 DE 4202454
(43) Veröffentlichungstag der Anmeldung: 04.08.1993
(73) Patentinhaber: SIEMENS AKTIENGESELLSCHAFT, 80333 München (DE)
(72) Erfinder: Lehmann, Volker, Dr., W-8000 München 21 (DE); Reisinger, Hans, Dr., W-8022 Grünwald (DE)

(56) Entgegenhaltungen:
- EP-A- 0 296 348
- FR-A- 2 339 953
- US-A- 3 962 052

## Beschreibung

Für viele technische Anwendungen werden perforierte Werkstücke, insbesondere als preiswerte optische oder mechanische Filter mit Porendurchmessern im »m und Sub-»m-Bereich benötigt. Solche Anwendungen sind z. B. isoporöse Membranen, rückspülbare Filter, Laminisatoren, Katalysatorträger, Elektroden für Batterien und Brennstoffzellen, Düsenplatten, Röhrengitter oder Filter für elektromagnetische Wellen wie z. B. Licht oder Mikrowellen.

Ein bekanntes Verfahren zur Herstellung solcher Filter ist die sogenannte LIGA-Technik (LIGA: Lithographie, Galvanik, Abformung). In der LIGA-Technik, die z. B. aus E.W. Becker et al, Microelectronic Engineering, Bd. 4 (1986) S. 35 ff. bekannt ist, wird eine dicke Fotolackschicht mit Hilfe von Synchrotronstrahlung strukturiert. Anschließend werden die Strukturen durch Galvanoformung und Abformtechnik mit Kunststoffen in das Filter übertragen. Mit der LIGA-Technik sind minimale Strukturbreiten von 2 »m erzielbar. In der Dimension parallel zur Durchgangsrichtung durch das Filter ist keinerlei Strukturierung möglich. Die erforderliche Anwendung von Synchrotronstrahlung macht dieses Verfahren sehr teuer.

Der Erfindung liegt daher das Problem zugrunde, ein Verfahren zur Herstellung eines perforierten Werkstückes anzugeben, mit dem Porendurchmesser in »m und Sub-»m-Bereich erzielt werden und das einfach durchführbar ist.

Dieses Problem wird erfindungsgemäß gelöst durch ein Verfahren nach Anspruch 1. Weitere Ausgestaltungen der Erfindung gehen aus den übrigen Ansprüchen hervor.

Da die Substratscheibe bei der elektrochemischen Ätzung als Anode geschaltet ist, bewegen sich Minoritätsladungsträger in dem n-dotierten Silizium zu der mit dem Elektrolyten in Kontakt stehenden ersten Oberfläche. An dieser Oberfläche bildet sich eine Raumladungszone aus. Da die Feldstärke im Bereich von Vertiefungen in der Oberfläche größer ist als außerhalb davon, bewegen sich die Minoritätsladungsträger bevorzugt zu diesen Punkten. Dadurch kommt es zu einer Strukturierung der Oberfläche. Je tiefer eine anfänglich kleine Unebenheit durch die Ätzung wird, desto mehr Minoritätsträger bewegen sich wegen der vergrößerten Feldstärke dorthin und desto stärker ist der Ätzangriff an dieser Stelle. Die Löcher wachsen im Substrat in der kristallographischen 〈100〉 - Richtung. Es ist daher vorteilhaft, ein Substrat mit 〈100〉 - Orientierung zu verwenden.

Die elektrochemische Ätzung von n-dotiertem Silizium zur Herstellung von Löchern oder Gräben ist z. B. aus EP 0 296 348 A1 bekannt, in der Gräben insbesondere für DRAM-Zellen auf diese Weise hergestellt werden. Deren Einsatz zum Ablösen von Plättchen von einem Substrat wird dort jedoch nicht in Betracht gezogen.

Der Ätzangriff ist abhängig von der Stromdichte in der Substratscheibe und von der Fluoridkonzentration im Elektrolyten. Durch Erhöhung der Stromdichte im Elektrolyten oder durch Verminderung der Fluoridkonzentration im Elektrolyten wird der Ätzangriff vergrößert. Diese Tatsache wird in dem erfindungsgemäßen Verfahren ausgenutzt, um bei Erreichen einer Tiefe der Löcher, die im wesentlichen der Dicke des fertigen Werkstücks entspricht, den Ätzabtrag so zu vergrößern, daß der Querschnitt der Löcher wächst. Da, wie oben ausgeführt, der Ätzangriff nur im unteren Bereich der Löcher stattfindet, bleibt der Querschnitt der Löcher im oberen Bereich, d. h. in der Nähe der ersten Oberfläche, dabei unverändert. Im unteren Bereich jedoch wachsen die Löcher. Die elektrochemische Ätzung wird solange fortgesetzt, bis benachbarte Löcher zusammenwachsen und dadurch die strukturierte Schicht als Plättchen abgelöst wird. Das Plättchen besteht aus zusammenhängendem Silizium, das die Löcher als Poren enthält. Dieses Plättchen ist als perforiertes Werkstück, z. B. als mechanischer oder optischer Filter verwendbar.

Mit dem erfindungsgemäßen Verfahren lassen sich Lochdurchmesser zwischen 20 »m und 50 nm gut herstellen.

Das Plättchen kann z. B. durch Diffusion oder Implantation mit einer anderen Dotierung versehen werden, als es die Substratscheibe ist. Auf diese Weise kann die Leitfähigkeit des perforierten Werkstücks eingestellt werden.

Durch Aufbringen von einer isolierenden Schicht an den Oberflächen des Plättchens kann die Oberflächenbeschaffenheit des perforierten Werkstückes beeinflußt werden. Dadurch wird das Werkstück isolierend. Durch Erzeugung eines thermischen Siliziumoxids oder Siliziumnitrid an der Oberfläche des Plättchens, wird dessen Oberfläche passiviert, widerstandsfähig gegen äußere Einflüsse und chemisch inert.

Die Stromdichte in der Substratscheibe ist durch Beleuchtung einer der ersten Oberfläche gegenüberliegenden Oberfläche der Substratscheibe besonders einfach zu beeinflussen. In diesem Fall wird das Ablösen des Plättchens durch Vergrößerung der Beleuchtung erzielt. In diesem Fall ist es weiterhin möglich, den Querschnitt der Löcher senkrecht zur ersten Oberfläche durch eine Änderung der Beleuchtung zu ändern. Durch kontinuierliche Änderung der Beleuchtung werden z. B. konische Löcher hergestellt.

Es liegt im Rahmen der Erfindung, vor der Bildung der Löcher, die erste Oberfläche der Substratscheibe mit einer Oberflächentopologie zu versehen. Auf diese Weise wird die erste Oberfläche gezielt mit Vertiefungen versehen, an denen der Ätzangriff beim elektrochemischen Ätzen beginnt. Dadurch wird die Anordnung der Löcher bestimmt.

Wird die erste Oberfläche mit einer Oberflächentopologie aus regelmäßig angeordneten Vertiefungen versehen, zeigt das Plättchen eine im wesentlichen konstante Dicke. In diesem Fall ist nämlich der Abstand der Löcher im wesentlichen gleich, so daß die Materialmenge zwischen benachbarten Löchern, die durch Vergrößerung des Ätzangriffs zum Ablösen des Plättchens abgeätzt werden muß, im wesentlichen gleich ist. Dann wachsen im wesentlichen alle Löcher gleichzeitig zusammen.

Darüberhinaus zeigt das fertige Plättchen in diesem Fall Strukturbreiten, d. h. Breiten der Löcher bzw. der dazwischen verbleibenden Stege, die innerhalb enger Grenzen konstant sind. Es wird eine Konstanthaltung der Strukturbreiten innerhalb von 10 % beobachtet.

In dem erfindungsgemäßen Verfahren werden, wenn die erste Oberfläche des Substrats vor der Bildung der Löcher mit einer Oberflächentopologie aus regelmäßig angeordneten Vertiefungen versehen wird, minimale Strukturbreiten bis 0,1 »m erzielt. Die Oberflächentopologie wird dabei z. B. nach Herstellung einer Fotolackmaske auf der ersten Oberfläche und anschließender alkalischer Ätzung der ersten Oberfläche erzeugt Zur Herstellung der Fotolackmaske wird dabei konventionelle optische Fotolithographie verwendet.

Es liegt im Rahmen der Erfindung, die Oberflächentopologie durch lichtinduzierte elektrochemische Ätzung in demselben Elektrolyten, in dem anschließend die Löcher geätzt werden, herzustellen.

Im folgenden wird die Erfindung anhand der Figuren und eines Ausführungsbeispiels näher erläutert.
- Fig. 1: zeigt einen Ausschnitt aus einer Siliziumscheibe, die mit einer Oberflächentopologie versehen ist.
- Fig. 2: zeigt einen Ausschnitt aus der Siliziumscheibe, in die durch elektrochemische Ätzung Löcher konstanten Querschnitts geätzt wurden.
- Fig. 3: zeigt einen Ausschnitt aus der Siliziumscheibe, in die durch elektrochemische Ätzung Löcher geätzt worden sind, deren Querschnitt durch Veränderung der Ätzparameter vergrößert wurde.
- Fig. 4: zeigt eine Substratscheibe, von der ein perforiertes Plättchen abgelöst wurde.
- Fig. 5: zeigt eine Draufsicht auf das perforierte Plättchen.

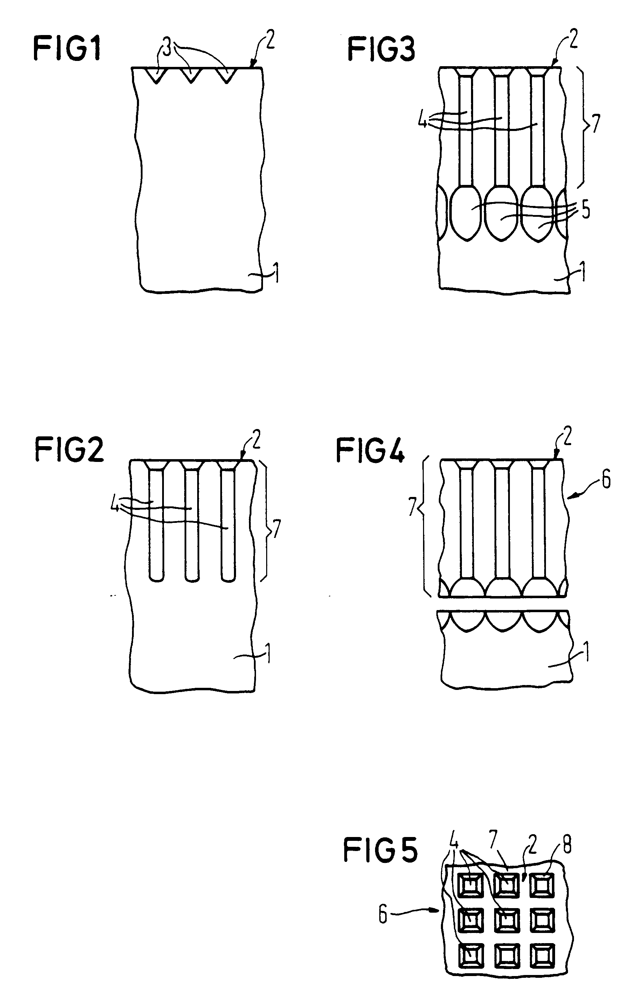

Eine Substratscheibe 1 aus n-dotiertem, einkristallinem Silizum mit einer elektrischen Leitfähigkeit von z. B. 5 Ohm cm ist an einer ersten Oberfläche 2 mit einer Oberflächentopologie versehen (s. Fig. 1). Die Oberflächentopologie umfaßt in regelmäßigen Abständen angeordnete Vertiefungen 3.

Die Vertiefungen 3 werden z. B. nach Herstellung einer Fotolackmaske mit Hilfe konventioneller Fotolithographie und anschließender alkalischer Ätzung hergestellt. Alternativ kann die Oberflächentopologie durch lichtinduzierte, elektrochemische Ätzung gebildet werden.

Die erste Oberfläche 2 der Substratscheibe 1 wird mit einem fluoridhaltigen, sauren Elektrolyten in Kontakt gebracht. Der Elektrolyt weist eine Flußsäurekonzentration von 1 bis 50 %, vorzugsweise 3 % auf. Dem Elektrolyten kann ein Oxidationsmittel, z. B. Wasserstoffsuperoxid, zugesetzt werden, um die Entwicklung von Wasserstoffbläschen auf der ersten Oberfläche 2 der Substratscheibe 1 zu unterdrücken.

Die Substratscheibe 1 wird als Anode verschaltet. Zwischen der Substratscheibe 1 und den Elektrolyten wird eine Spannung von 0 - 20 V, vorzugsweise 3 Volt angelegt. Die Substratscheibe 1 wird von der Rückseite her mit Licht beleuchtet, so daß eine Stromdichte von z. B. 10 mA/cm² eingestellt wird. Ausgehend von den Vertiefungen 3 (s. Fig. 1) werden bei der elektrochemischen Ätzung Löcher 4 erzeugt, die senkrecht zur ersten Oberfläche 2 verlaufen (s. Fig. 2). Dabei wird eine strukturierte Schicht 7 an der ersten Oberfläche 2 gebildet.

Nach etwa 60 Minuten Ätzzeit wird die anodische Stromdichte auf z. B. 30 mA/cm² erhöht. Dabei wird die Spannung zwischen Elektrolyt und Substratscheibe 1 auf 2 Volt reduziert. Die Stromdichte wird weiterhin durch Beleuchtung der Rückseite der Substratscheibe 1 eingestellt.

Durch die geänderten Parameter bei der elektrochemischen Ätzung vergrößern sich die Querschnitte der Löcher 4 im unteren Bereich bei der weiteren Ätzung. Es bilden sich am Boden jedes Loches 4 höhlenförmige Erweiterungen 5 aus. Der Querschnitt der höhlenförmigen Erweiterungen 5 wächst, bis das jeweils benachbarte höhlenförmige Erweiterungen 5 trennende Silizium weggeätzt ist (s. Fig. 4). Dieses ist mit den angegebenen Prozeßparametern nach ungefähr 10 Minuten der Fall.

Es bildet sich ein Plättchen 6, das aus freitragendem Silizium mit den Löchern 4 besteht. Mit den angegebenen Prozeßparametern wird eine Dicke des Plättchens von 30 »m erzielt. Diese Dicke liegt weit unter den durch konventionelles sägen erzielbaren Dicken von Siliziumscheiben.

Fig. 5 zeigt eine Aufsicht auf das Plättchen 6. Die das Plättchen bildende, freitragende strukturierte Schicht 7 zeigt eine gleichmäßige Verteilung der Löcher 4, die runden oder quadratischen Querschnitt haben. Die Löcher 4 haben einen Durchmesser von z. B. 2 »m und sind in einem Abstand von z. B. 1,5 »m angeordnet. Zur ersten Oberfläche 2 hin weiten sich die Löcher 4 auf. Das ist eine Folge der Oberflächentopologie, die an der ersten Oberfläche der Substratscheibe erzeugt wurde. Diese Aufweitungen 8 im oberen Bereich der Löcher haben den Vorteil, daß das Plättchen 6 als Filter rückspülbar ist. Durch eine kurzzeitige Umkehr der Strömungsrichtung läßt sich im Betrieb der Filter reinigen.

Zur Veränderung der elektrischen Leitfähigkeit kann das Plättchen 6 anschließend in bekannter Weise mit einer Dotierung versehen werden.

Zur Verbesserung der Oberfläche kann das Plättchen mit einem thermischen Siliziumoxid oder einem thermischen Siliziumnitrid versehen werden. Dadurch wird die Oberfläche chemisch inert und das Plättchen kann in entsprechenden Umgebungen als Werkstück eingesetzt werden.

Da das Plättchen 6 aus Silizium besteht, kann es, falls es die jeweilige Anwendung erfordert, bei hohen Temperaturen ausgeglüht oder regeneriert werden.

## Patentansprüche

1. Verfahren zur Herstellung eines perforierten Werkstückes,
- bei dem in einer ersten Oberfläche (2) einer Substratscheibe (1) aus n-dotiertem, einkristallinem Silizium durch elektrochemische Ätzung Löcher (4) senkrecht zur ersten Oberfläche gebildet werden, so daß eine strukturierte Schicht (7) entsteht, wobei die elektrochemische Ätzung in einem fluoridhaltigen, sauren Elektrolyten erfolgt, in dem die Substratscheibe als Anode verschaltet ist, in dem die erste Oberfläche (2) mit dem Elektrolyt in Kontakt steht und in dem eine den Ätzabtrag beeinflussende Stromdichte eingestellt ist,
- bei dem bei Erreichen einer Tiefe der Löcher (4), die im wesentlichen der Dicke des fertigen Werkstücks entspricht, durch Erhöhung der Stromdichte im Elektrolyten oder durch Verminderung der Fluoridkonzentration der Ätzangriff vergrößert wird, so daß der Querschnitt der Löcher (4) wächst und die strukturierte Schicht (7) als Plättchen (6), aus dem das Werkstück gebildet wird, abgelöst wird.

2. Verfahren nach Anspruch 1,
bei dem die Substratscheibe eine 〈100〉 -Scheibe ist.

3. Verfahren nach Anspruch 1 oder 2,
bei dem die Stromdichte durch Beleuchtung einer der ersten Oberfläche (2) gegenüberliegenden zweiten Oberfläche der Substratscheibe (1) eingestellt wird.

4. Verfahren nach einem der Ansprüche 1 bis 3,
bei dem der Elektrolyt 1 bis 50 % Flußsäure (HF) enthält.

5. Verfahren nach Anspruch 4,
bei dem der Elektrolyt zusätzlich ein Oxidationsmittel enthält.

6. Verfahren nach einem der Ansprüche 1 bis 5,
bei dem an der ersten Oberfläche (2) der Substratscheibe (1) vor der Bildung der Löcher (4) eine Oberflächentopologie erzeugt wird, die die Anordnung der Löcher bestimmt.

7. Verfahren nach Anspruch 6,
bei dem die Oberflächentopologie aus regelmäßig angeordneten Vertiefungen (3) der ersten Oberfläche (2) besteht.

8. Verfahren nach Anspruch 6 oder 7,
bei dem die Oberflächentopologie durch Herstellung einer Fotolackmaske auf der ersten Oberfläche (2) und anschließende alkalische Ätzung der ersten Oberfläche (2) erzeugt wird.

9. Verfahren nach Anspruch 6 oder 7,
bei dem die Oberflächentopologie durch elektrochemisches Ätzen mit dem Elektrolyten dadurch erzeugt wird, daß auf der ersten Oberfläche (2) unter Verwendung einer Lichtquelle mit einer Wellenlänge kleiner als 1100 nm ein Beleuchtungsmuster erzeugt wird und daß die Stromdichte im Elektrolyten so eingestellt wird, daß nur an belichteten Stellen des Beleuchtungsmusters lokal ein anodischer Minoritätsträgerstrom über die Substratscheibe fließt, der einen Ätzabtrag der ersten Oberfläche (2) bewirkt.

10. Verfahren nach einem der Ansprüche 1 bis 9,
bei dem durch Dotierung des Plättchens (6) die Leitfähigkeit des Werkstücks eingestellt wird.

11. Verfahren nach einem der Ansprüche 1 bis 10,
bei dem an den Oberflächen des Plättchens (6) mindestens eine isolierende Schicht erzeugt wird.

12. Verfahren zur Herstellung eines mechanischen oder optischen Filters unter Verwendung des Verfahrens nach einem der Ansprüche 1 bis 11.

## Claims

1. Method for producing a perforated workpiece,
- in which holes (4) are formed at right angles to a first surface (2) in a first surface of a substrate wafer (1), which is made of n-doped, monocrystalline silicon by electrochemical etching, so that a structured layer (7) is produced, the electrochemical etching being carried out in an acidic electrolyte, containing fluoride, in which electrolyte the substrate wafer is connected as the anode and in which the first surface (2) is in contact with the electrolyte and in which a current density is set which influences the etching removal,
- in which the etching attack is increased by increasing the current density in the electrolyte or by reducing the fluoride concentration, when the holes (4) reach a depth which corresponds essentially to the thickness of the complete workpiece, so that the cross-section of the holes (4) grows and the structured layer (7) is separated, as a platelet (6) from which the workpiece is formed.

2. Method according to Claim 1, in which the substrate wafer is a 〈100〉 wafer.

3. Method according to Claim 1 or 2, in which the current density is set by light exposure of a second surface, which is opposite the first surface (2), of the substrate wafer (1).

4. Method according to one of Claims 1 to 3, in which the electrolyte contains 1 to 50% hydrofluoric acid (HF).

5. Method according to Claim 4, in which the electrolyte additionally contains an oxidation agent.

6. Method according to one of Claims 1 to 5, in which a surface topology which determines the arrangement of the holes is produced on the first surface (2) of the substrate wafer (1) before the formation of the holes (4).

7. Method according to Claim 6, in which the surface topology comprises regularly arranged depressions (3) in the first surface (2).

8. Method according to Claim 6 or 7, in which the surface topology is produced by production of a photo-resist mask on the first surface (2) and subsequent alkaline etching of the first surface (2).

9. Method according to Claim 6 or 7, in which the surface topology is produced by electrochemical etching with the electrolyte, in such a manner that a light exposure pattern is produced on the first surface (2) using a light source having a wave length of less than 1100 nm, and in that the current density in the electrolyte is set such that an anodic minority carrier current flows locally via the substrate wafer only at exposed points in the light exposure pattern, which current produces etching removal of the first surface (2).

10. Method according to one of Claims 1 to 9, in which the conductivity of the workpiece is set by doping the platelet (6).

11. Method according to one of Claims 1 to 10, in which at least one insulating layer is produced on the surfaces of the platelet (6).

12. Method for production of a mechanical or optical filter using the method according to one of Claims 1 to 11.

## Revendications

1. Procédé pour la fabrication d'une pièce d'oeuvre perforée,
- selon lequel, dans une première surface (2) d'une plaque (1) en silicium monocristallin dopé N formant un substrat, des trous (4) sont formés perpendiculairement à la première surface par gravure électrochimique, de manière à obtenir une couche structurée (7), la gravure électrochimique ayant lieu dans un électrolyte acide contenant du fluorure, dans lequel la plaque formant le substrat est reliée à l'anode, dans lequel la première surface (2) est en contact avec l'électrolyte et dans lequel une intensité de courant influençant l'érosion est établie,
- selon lequel, lorsque l'on a atteint une profondeur des trous (4) qui correspond sensiblement à l'épaisseur de la pièce d'oeuvre finie, l'attaque est renforcée par augmentation de l'intensité de courant dans l'électrolyte ou par diminution de la concentration en fluorure, de manière à ce que la section transversale des trous (4) grandisse et que la couche structurée (7) se détache en forme de plaquette (6) à partir de laquelle la pièce d'oeuvre est réalisée.

2. Procédé selon la revendication 1, selon lequel la plaque formant le substrat est une plaque 〈100〉.

3. Procédé selon la revendication 1 ou 2, selon lequel l'intensité de courant est réglée par l'éclairage d'une seconde surface de la plaque (1) formant le substrat située à l'opposé de la première surface (2).

4. Procédé selon l'une des revendications 1 à 3, selon lequel l'électrolyte contient de 1 à 50% d'acide fluorhydrique (HF).

5. Procédé selon la revendication 4, selon lequel l'électrolyte contient, en plus, un oxydant.

6. Procédé selon l'une des revendications 1 à 5, selon lequel une topologie de surface qui détermine l'agencement des trous est réalisée sur la première surface (2) de la plaque (1) formant le substrat, avant la formation des trous (4).

7. Procédé selon la revendication 6, selon lequel la topologie de surface consiste en creux (3) de la première surface (2) disposés de manière régulière.

8. Procédé selon la revendication 6 ou 7, selon lequel la topologie de surface est réalisée par fabrication d'un masque de laque photosensible sur la première surface (2) et, ensuite, par corrosion alcaline de la première surface (2).

9. Procédé selon la revendication 6 ou 7, selon lequel la topologie de surface est réalisée par gravure électrochimique avec l'électrolyte en faisant en sorte qu'un modèle d'éclairage soit produit sur la première surface (2) en utilisant une source lumineuse ayant une longueur d'onde inférieure à 1100 nm et que l'intensité de courant dans l'électrolyte soit réglée de manière à ce qu'un flux anodique de porteurs minoritaires circule localement sur la plaque formant le substrat uniquement aux endroits éclairés du modèle d'éclairage, ce flux provoquant une érosion de la première surface (2).

10. Procédé selon l'une des revendications 1 à 9, selon lequel la conductibilité de la pièce d'oeuvre est réglée en dopant la plaquette (6).

11. Procédé selon l'une des revendications 1 à 10, selon lequel au moins une couche isolante est formée sur les surfaces de la plaquette (6).

12. Procédé pour la fabrication d'un filtre mécanique ou optique et utilisant le procédé selon l'une des revendications 1 à 11.
